# EUROPEAN PATENT SPECIFICATION

(11) **EP 1 878 043 B1**
(45) Date of publication and mention of the grant of the patent: **03.11.2021**
(21) Application number: 06710851.4
(22) Date of filing: 08.02.2006
(51) Int. Cl.: H01L 21/306

(54) **LOW-DIELECTRIC CONSTANT CRYPTOCRYSTAL LAYERS AND NANOSTRUCTURES**
CRYPTOKRISTALLINE LAGEN MIT NIEDRIGER DIELEKTRIZITÄTSKONSTANTE UND NANOSTRUKTUREN
NANOSTRUCTURES ET COUCHES CRYPTOCRISTALLINES A FAIBLE CONSTANTE DIELECTRIQUE

(30) Priority: 16.03.2005 TR 200500923
(43) Date of publication of application: 16.01.2008
(73) Proprietor: Tubitak, 06100 Ankara (TR)
(72) Inventor: KALEM, Seref, 34353 Besiktas, Istanbul (TR)
(86) International application number: PCT/IB2006/050406
(87) International publication number: WO 2006/097858

(56) References cited:
- JP-A- 1 010 614
- S. KALEM: "Possible low-k solution and other potential applications"[Online] 12 August 2004 (2004-08-12), XP002409771 Retrieved from the Internet: URL:http://www.eurosemi.eu.com/eurosemi200 4/front-end/printer-friendly.php?newsid=54 92> [retrieved on 2006-11-27]
- S. KALEM: "Synthesis of ammonium silicon fluoride cryptocrystals on silicon by dry etching" APPLIED SURFACE SCIENCE, vol. 236, no. 1-4, 15 September 2004 (2004-09-15), pages 336-341, XP002409772 NL
- S. KALEM ET AL.: "Possibility of fabricating light-emitting porous silicon from gas phase etchants" OPTICS EXPRESS, vol. 6, no. 1, 3 January 2000 (2000-01-03), pages 7-11, XP002409773
- R. W. FATHAUER ET AL.: "Visible luminescence from silicon wafers subjected to stain etches" APPLIED PHYSICS LETTERS, AIP, AMERICAN INSTITUTE OF PHYSICS, MELVILLE, NY, US, vol. 60, no. 8, 24 February 1992 (1992-02-24), pages 995-997, XP000292204 ISSN: 0003-6951
- M. SAADOUN: "Vapour-etching-based porous silicon: a new approach." THIN SOLID FILMS, vol. 405, no. 1-2, 22 February 2002 (2002-02-22), pages 29-34, XP002409942
- FUJIMO S ET AL: "SILICON WAFER DIRECT BONDING THROUGH THE AMORPHOUS LAYER" JAPANESE JOURNAL OF APPLIED PHYSICS, JAPAN SOCIETY OF APPLIED PHYSICS, TOKYO, JP, vol. 34, no. 10B, PART 2, 15 October 1995 (1995-10-15), pages L1322-L1324, XP000702224 ISSN: 0021-4922
- ASTROVA E V ET AL: "EFFECT OF CHEMICAL SURFACE TREATMENT ON P-LAYER FORMATION IN THE INTERFACE REGION OF DIRECTLY BONDED SI WAFERS" SEMICONDUCTOR SCIENCE AND TECHNOLOGY, IOP, BRISTOL, GB, vol. 8, no. 9, 1 September 1993 (1993-09-01), pages 1700-1705, XP000417397 ISSN: 0268-1242
- None

## Description

Low-dielectric constant cryptocrystals may be used in conjunction with future generation integrated circuits and devices. These cryptocrystals were grown by Chemical Vapor Processing (CVP) method [S. Kalem and O. Yavuz, OPTICS EXPRESS 6, 7(2000)] consisting of the exposure of Silicon surface to vapors of acid mixtures. The cryptocrystal stands for a material that is so finely grained that no distinct particles are discerned under optical microscope. State of matter arranged in this way with such minute crystals is said to be cryptocrystal or cryptogranular. This type of crystals can exhibit extraordinary properties which can be used in various fields.

The invention relates to cryptocrystals and particularly to Ammonium X Fluoride (AXF), which have been derived from state-of-the-art wafers and having a general formula (NH4)2XF6 - (wherein X =Si, Ge, C) named as 'ammonium X-fluoride'.

There is no report in litterature on the above mentioned optical quality dielectric Ammonium X-Fluoride cryptocrystals.

Ammonium Silicon Fluoride(ASiF) material was shown to be formed on Silicon wafers when Ammonium Fluoride NH₄F is reacted with Si on the wafer surface [M.Niwano, K. Kurita, Y. Takeda and N.Miyamoto, Applied Physics Letters 62, 1003(1993)].

As explained in another document, Ammonium Silicon Fluoride has been found on the walls of vacuum chambers and in the vacuum exhaust lines during plasma assisted semiconductor cleaning and deposition processings [S.Munley, I.McNaught, D.Mrotek, and C.Y.Lin, Semiconductor International, 10/1,(2001)].

It has also been shown that a light emitting powders of Ammonium Silicon Fluoride can be derived from porous Silicon using HF/HNO3 [M.Saadoun, B.Bessais, N.Mliki, M.Ferid, H.Ezzaouia, and R.Bennaceur, Applied Surface Science 210, 240(2003)].

Similarly, [H.Ogawa, T.Arai, M.Yanagisawa, T.Ichiki and Y.Horiike, Jpn. J. Applied Physics 41, 5349(2002)] have shown that Ammonium Silicon Fluoride was formed on Silicon wafers when residual natural oxide reacts with hot Ammonium(NH₃) and Nitrogen Fluoride(NF₃) on the wafer surface.

Also, It was reported that ammonium silicon fluoride have been formed when HF and NH₃ gases are reacted on SiO₂ under vacuum. [P.D.Agnello, IBM J. of Research and Development 46, Number 2/3, 2002)].

There is no application quality cryptocrystal structure in the above mentioned works. Moreover, in these works ammonium silicon fluoride has been obtained as an unintentional, irregular, disordered and contaminated by-product.

There is no report in litterature on Ammonium X-Fluoride micro- and nanowires. (X=Silicon, Germanium, Diamond)

There is no report on the fact that the dielectric constant of Ammonium X-Fluoride cryptocrystals can be tuned over a large scale and they can be used as insulator.

Micro and nano-electronics are the most important fields of application. According to International Road Map for Semiconductors(ITRS) [C.Case, Solid State Technology, Jan., 47(2004)][P.Zeitzoff, R.W.Murto, H.R.Huff, Solid State Technology, 71(2002)], semiconductor industry needs a low-dielectric constant(k) intermetal insulators with dielectric constant which is well under k=3.0. for high performance interconnections. Therefore, it is very important to develop low-k dielectrics which are compatible for future integrated circuitry(IC) production. On the other hand, there is a continuing effort in finding a high-k dielectrics for CMOS gate insulation under 1 nanometer for 50 nanometer fabrication node. Our invention also offers a solution to high-k issue with cryptocrystal layers whose dielectric constant can be set at a desired value by diffusion.

In accordance with historical Moore law [G.E.Moore, Electronics 38, 114(1965)][ G.E.Moore, IEDM Technical Digest, Washington DC, 11(1975)], down-scaling continues in CMOS technology. Multi-level metallisation is required to accomodate signal integration of a number of active elements. Electrical resistance and parasitic capacitances in these metal interconnects are important factors limiting the IC performance in next generation systems. This causes the industry to move from Aluminum-SiO₂ to Copper/ low-k configuration. While the cupper decreases the line resistance, the low-k dielectric decreases the parasitic capacitance between metal lines.

In order to overcome difficulties in downscaling of transistor dimensions, the capacitance per unit area is to be kept constant. Therefore, there is a need for high-k value dielectrics. These dielectrics can be oxides and silicates such as Al₂O₃, ZrO₂, HfO₂ . C. J. Parker, G. Lucovsky and J. R. Hauser, IEEE Electron. Device Lett. (1998); Y. Wu and G. Lucovsky, IEEE Electron. Device Lett. (1998); and H. Yang and G. Lucovsky, IEDM Digest, (1999) have suggested solutions in using these materials. However, there are very tough challenges to overcome concerning the economic cost and number of interfacial defects. Our cryptocrystal technology can offer potential solutions in this field. For example, maintaining advantages of natural gate oxide, a high-k dielectric can be formed using cryptocrystals.

The metal lines in integrated circuits are electrically insulated from each other by dielectric insulators. As the IC size becomes smaller, distances between metal lines are decreased, thus leading to an increased capacitances. This causes RC delays, power loss, capacitively induced signals or cross-talks. There is a need for low-dielectric constant insulation layers in lieu of SiO₂.

Polymers with dielectric constant lower than that of SiO2 are used as interconnect insulator. But, the fact that the polymers are not strong, is an important disadvantage.

Oxides doped with Carbon can be a solution for the low-k dielectrics. It is possible to obtain oxides with dielectric constant smaller than 3.0. They present great disadvantages concerning durability.

The performance characteristics gained by down sizing active circuit elements in IC production can be lost in interconnects and packaging elements. In this case, not the speed of transistor but the RC delays at interconnects become important. Moreover, with decreasing dimensions, deeper metal lines are required, thus making intermetal capacitance more important than the interlevel capacitance. In order to overcome these difficulties superior low-k dielectrics and new fabrication methods are required. Current low-k dielectrics consist of oxides and polymers. Cryptocrystals can be a potential solution. Thus, high performance IC's can be realized by avoiding cross-talks among adjacent electric circuits.

One of the approaches is a method using air gaps to lower capacitances [B.Shieh et. al., IEEE Electron Device Letters, 19, no.1, p.16-18(1998)] [D.L. Wollesen, Low capacitance interconnection, US. Pat. No: 5,900,668, issued May 4, 1999]. In these approachesi SiO2 has been used as interlevel and intermetal dielectric. U.S. Pat. Nos. US 5,470,802 , US 5,494,858 , US 5,504,042 and US 5,523,615 patents relate to the possibility of decreasing capacity by using air gaps. But, in these methods, harsh chemicals should be used to form air-gaps. Cryptocrystal technology can offer easier, damage free, low cost solutions in fabricating air-gaps.

This invention relates to ASiF cryptocrystals whose dielectric value can be tuned by several methods and can be synthesized on Si and Si-based wafers. By diffusion, the dielectric constant of ASiF cryptocrystals can be tuned from its minimum value of 1.50 to much higher values(desired). Thus, other properties such as ferroelectric and optical emission can be possessed by cryptocrystals.

Possible Low-k solution and other potential applications [European Semiconductor, Vol.26, No.7, July 2004, pages 31-34] was published in European Semiconductor proposing a cryptocrystalline material for integration as a low-k dielectric layer into a reliable semiconductor process. Physical, chemical and structural properties as well as the growth conditions of cryptocrystal layers synthesized on silicon wafers have been reported. It was proposed as a low-k solution to meet the need of the advanced semiconductor manufacturing industry.

Synthesis of ammonium silicon fluoride cryptocrystals on silicon by dry etching [Applied Surface Science, Vol.236, Nr. 1-4, September 2004, pages336-341] is about the synthesis of ammonium silicon hexafluoride cryptocrystals on silicon wafers from the vapour of hydrofluoric acid HF and nitric acid HNO3 at room temperature. The synthesis of a stable cryptocrystal layer was demonstrated and the physical, chemical and structural properties of the resulting layer have been investigated using scanning electron microscopy, Fourier transformed infrared spectroscopy and x-ray diffraction measurements. It was also shown that the cryptocrystal layer is intact up to about 150 °C.

Important alternative to low-cost and high performance low-k technology. Because, it is derived from npotential integrated circuit wafers and has a dielectric constant lower than 2.00. This value is smaller than that predicted by ITRS for the year 2007 and beyond.

Important applications in Si CMOS technology and GaAs technology, in increasing the performance of heterojunction bipolar transistors(HBT), high density information storage and information security, microelectronics packaging, photonic component production, IC system cooling, technology integration and sensor production.

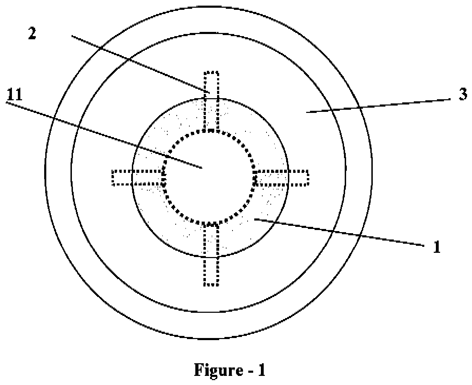

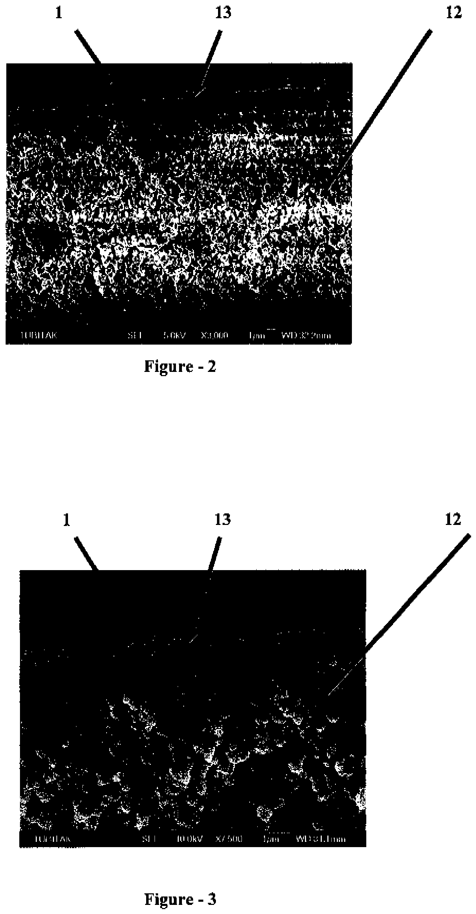

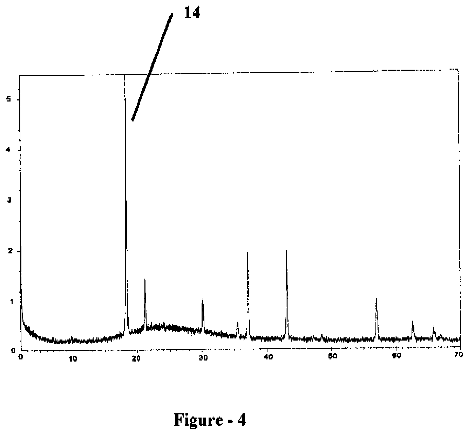

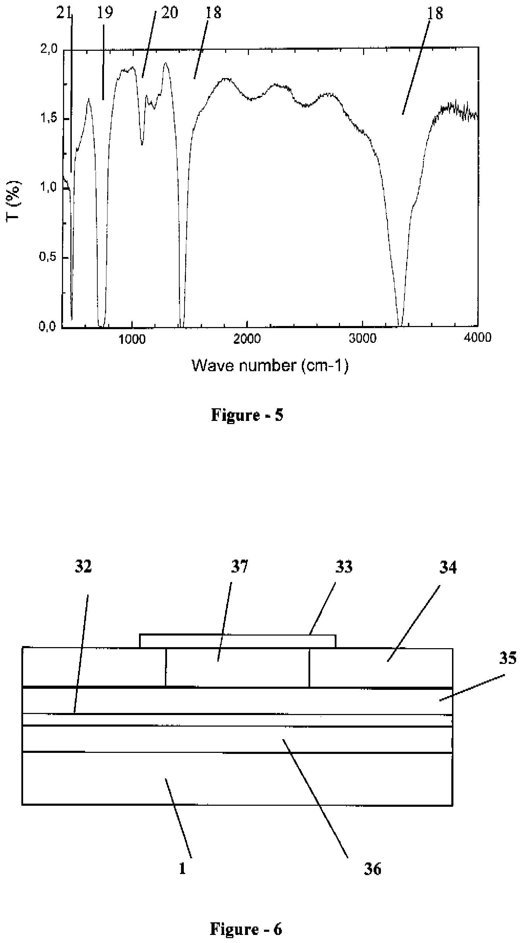

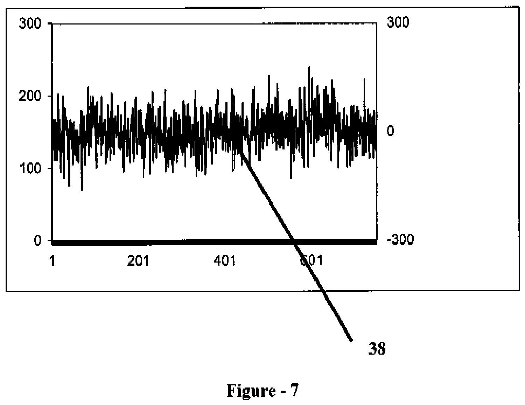

The following figures relate to cryptocrystal properties, methods of cryptocrystal layer production and devices in which cryptocrystal layers can be used.
Figure -1 Cryptocrystal production apparatus which is made of teflon, consisting of a liquid containing chamber exposure orifice, the sample holder, vapour exhaust channels and heater
Figure -2 A detailed sketch of the sample holder where the wafer is located.
Figure-3 The surface image of a cryptocrystal layer grown with the apparatus mentioned above as taken under polarization optical microscope
Figure -4 Cross-sectional micrograph of a cryptocrystal layer as taken with Scanning Electron Microscope(SEM) at 3.000 magnification. Cryptocrystal structural details are better seen compared to Figure-3. The thickness of this cryptocrystal layer is 21 µm.
Figure -5 The interface between the cryptocrystal and the wafer as seen at SEM with a magnification of 7.500. The surface quality and the derivation of cryptocrystals from wafer are clearly shown. There is relatively smooth interface that is free from craks and cavities and the cryptocrystal layer sticks well to the wafer.
Figure -6 X-ray diffraction analysis show that the layers are (NH4)2SiF6 and the crystals belong to (4/m-32/m) isometric hexoctahedral system with Fm3m space group [W.L.Roberts, G.R.Rapp and T.J. Cambell, Enc. of Minerals, 2nd Ed., Kluwer Academic Publishers, Dordrecht, 1990].
Figure -7 The changes that occurred at the ASIF surface and behavior of the dielectric structure after annealing are shown. Although, the surface is not protected during annealing, there is still a part adherent to the surface after 200°C. Moreover, bulk crystals of various dimensions are formed on the surface.
Figure -8 It is possible to write selectively on the wafer surface to form lithographic structures without using photolithography. The figure shows the result of such an experiment
Figure -9 Another important feature of cryptocrystals is that they can be transformed into micro- and nano-wires. It is possible to form straight wires with dimensions ranging from few nanometers up to 1000nm as shown in the figure. With this method, the straight wires with lengths up to 100 µm can be produced.
Figure -10 The results of x-ray diffraction analysis have been confirmed by FTIR analysis through the presence of vibrational modes of (NH⁴)₂SiF₆ groupings. The analysis indicate that the observed vibrational modes N-H and Si-F in at 480cm⁻¹, 725cm⁻¹, 1433cm⁻¹ and 3327cm⁻¹ belong to N-H and Si-F bondings.
Figure -11 Deleted
Figure -12 The figure shows how the capacitances between the Base-Collector and Source-Collector can be reduced using cryptocrystal methods.
Figure -13 A crypto chip for generating random numbers. Cryptocrystal layer as window is just in front of laser or LED cavity
Figure -14 Laser scattering trough a cryptocrystal layer and production of physical oneway function using cryptocrystal chip.

The numbers in figures and their correspondence are given below:
1.Wafer or Substrate
2.Gas exhaus channel,
3. Teflon container
4.Vapor chamber
5.Chemical mixture
6.Thermometer
7 Ph meter
8 Teflon block
9 Liquid exctraction valve
10 Nitrogen flashing valve
11 Process chamber orifice
12 ASiF cryptocrystals
13 Wafer and cryptocrystal interface
14 (111) major diffraction peak
15 Single ASiF crystals
16 Cryptocrystal dots formed selectively on Si
17 ASiF micro- and nano-wires
18 N-H vibrational modes
19 Si-O vibrational mode
20 Si-F vibrational mode
21 Deformation mode
22 Transistor gate metal
23 Transistor source metal
24 Source
25 Drain metal
26 Drain
27 Gate oxide layer (SiO2)
28 HBT collector
29 Cryptocrystal HBT source region
30 Cryptocrystal HBT Drain region
31. Hetero Bipolar transistor(HBT) Base region
32. VECSEL active region
33. Protection layer
34. Insulator
35. Top Bragg reflector
36. Bottom Bragg reflector
37. Cryptocrystal transparent window
38. He-Ne laser scattering through cryptocrystal

A method for synthesizing ammonium silicon fluoride (ASiF) on Silicon (Si) and Si based wafers has been developed. In this method, we have used the vapor phase growth technique that we have already developed [S. Kalem and O. Yavuz, OPTICS EXPRESS 6, 7(2000)]. With this method, we have grown cryptocrystal layers by having the vapors of Hydrofluoric Acid (HF) and Nitric Acid (HNO3) reacted on wafer surface. Cryptocrystal layers having white granular color were synthesized on wafers at 1µm/hour growth rates.

The advantages of this technique are : i) no electrical contacts are required, ii)possibility of writing on surfaces selectively, iii) layers are homogeneous, iv) thickness can be controlled, v) possibility of forming diffusion barrier in etching processes, vi) cost effective compared to other conventional techniques vii) has a cryptoclrystalline property.

The objective of this invention is to provide a silicon wafer bonding method, the method including the formation of cryptocrystal layers on the surfaces of two wafers by Chemical Vapor Processing where a vapor mixture of chemicals is reacted on the wafers which involves the following steps:
a) preparing a Teflon reaction chamber (3) comprising an orifice (11) and conduct ultrasound cleaning processes
b) Preparation of chemical mixture of HF and HNO3 with ratios (4-10):(1-8) and 25-50% hidrofluoric acid (HF) and 55-75% nitric acid (HNO3),
c) Flushing the mixure with Nitrogen and priming mixture with a piece of silicon wafer for 10 seconds,
d) Closing entirely the orifice of the reaction chamber (11) with the wafer to be processed,
e) ensuring the evacuation of reaction by-products in the reaction chamber through exhaust channels,
f) Adjusting temperature and pH between 10°C- 50°C and 1-6 respectively
g) Having the vapor of HF and HNO3, reacted on the silicon wafer surface according to the following Silicon mediated reaction

   Si + 6HF + 2HN03 → (NH4)2SiF6 + 3O2

   thereby transforming the wafer surface into a cryptocrystal layer at a rate of 1 µm/h
   the method further including pressing the wafer surfaces under H2O, Nitrogen or Hydrogen at high temperature.

Here are the properties of wafers used in cryptocrystal layer production:
1.Resistivities between 5-10 Ohm-cm
2.p-type, Boron doped, (100) and (111) oriented Si
3.n-type, Phosphor doped, (100) and (111) oriented Si
4.Silicon native oxide(thermal oxide) on Silicon SiO₂/Si
5.Stochiometric Si₃N₄ on Silicon (Si/Si₃N₄)
6.

   Si₁₋ₓGeₓ, x<0.3 (Si₁₋ₓGex on Si)

Cryptocrystal production apparatus consists of a substrate(1), gas exhaust channel for reaction by-products(2), teflon container (3), vapor processing chamber(4), chemical mixture(5), Ph meter (7), chemical extraction gate (9), heater(8) and temperature controller(6), orifice and sample holder(11) and nitrogen flashing(10).

Cryptocrystal layers are formed of undiscernable particles(12) as evidenced by optical polarization microscope and even by scanning electron microscope(SEM). In addition, they have smooth interfaces(13) and are well integrated to wafer as evidenced SEM interfacial studies.

X-ray diffraction analysis indicate that the cryptocrystals grown preferentially in the (111) direction (14). Diffraction peaks and their relative intensities are summarized in Table1.

Table-1 X-ray diffraction data summarizing diffraction peaks observed in cryptocrystals of ASiF. Wherein, teta, d and l/l1 are diffraction angle, distance between planes and normalised diffraction intensities, respectively.

| Peak No: | 2 Teta (Degree) | d | l/l1 |
|---|---|---|---|
| 1 | 18.3401 | 4.83355 | 100 |
| 2 | 21.2009 | 4.18734 | 19 |
| 3 | 30.1452 | 2.96221 | 15 |
| 4 | 35.4952 | 2.52703 | 7 |
| 5 | 37.1360 | 2.41906 | 39 |
| 6 | 43.1362 | 2.09545 | 43 |
| 7 | 57.0333 | 1.61348 | 22 |
| 8 | 62.6247 | 1.48219 | 9 |
| 9 | 65.8394 | 1.41739 | 7 |

Cryptocrystals(12) having white color, are formed on wafers(1) in the form of regular thin layers. The annealing experiments indicatate indicate that ASiF stays on the surface up to about 150oC. It is decomposed above this temperature.

Depending on annealing temperature, bulk crystals(15) of ASiF are formed on the surface. The dimensions of these crystals can be up to 15µmx30µm.

Cryptocrystal can be selectively realized in any shape such as dots(16), wires and complex branches including ordered flowers on wafers,

Nanowires(17) with dimensions ranging from few nanometers up to one micrometer and lengths up to 50µm were produced. Moreover, variety of nanometer structures and particularly nanobranches were produced.

Room temperature optical properties of ASiF cryptocrystals exhibit the vibrational peaks as summarized in Table-2. The frequencies are associated with vibrations of various bonding configurations of N-H(18), Si-O(19) ve and Si-F(20) modes in ASiF. The Si-O vibrations are related to the presence of a native oxide layer at the interface.

Table 2, A summary of FTIR data for ASiF cryptocrystals, wherein, VS:Very Strong, S:Strong, M:Medium, W:Weak, VW:Very Weak.

**Table 2**

| Frequency w(cm⁻¹) | Description | Intensity |
|---|---|---|
| 480 | N-H wagging or Si-F deformation | VS |
| 725 | Si- F stretching | VS |
| 1083 | Si-O stretching (Str) | M |
| 1180 | Si-O Asymmetric stretching(Asym Str) | W |
| 1433 | N-H Bending or deformation mode | VS |
| 2125 | Si-H Stretching | VW |
| 3327 | N-H symmetric stretching(sym str) | VS |
| 3449 | N-H Degenerate stretching | M |

FTIR analysis indicate that ASiF has strong absorption notches at 3µm(18), 7µm(18), 13.6µm(20) and 20.8µm(21), and thus they can be used in optical applications.

Cryptocrystal layer is placed in between Source(23)-Collector(28) and Drain (25)-Collector(28) in (Hetero Bipolar Transistor, HBT) transistors to reduce capacitances and thus increasing high frequency performance of HBT's. Above mentioned capacitances play an important role in III-V compound semiconductor based (GaAs/AIGaAs) HBT's [M.Mochizuki, T. Nakamura, T.Tanoue and H.Masuda, Solid State Electronics 38, 1619(1995)] and SiGe based HBT's [U.Konig and H.Dambkes, Solid State Electronics 38, 1595(1995)]. In such a device, cryptocrystal layers are located in both sides of the Base region(31) and underneath of the Source(29) and the Drain(30) regions. In this structure, after transistor structure formed, both sides of the Base have been transformed into low dielectric constant cryptocrystal regions using above mentioned methods.

With increasing demand for ultra high density and high speed applications, there is an increasing interest for new high performance information storage systems [H.Coufal and G.W. Burr, International Trends in Optics, 2002] [US Pat. No. 6,846,434]. Using cryptocrystals, it would be possible to obtain ultra high density memory cells(20) on electronic wafers. In this application it has been possible to write selectively on Silicon based wafers by forming cryptocrystal cells(16). The fact that cryptocrystals can have phase change(16) at relatively low temperatures, offers the possibility of erasing and rewriting. Thus, the fast phase change feature at low temperatures enables fast writing applications. Moreover, with 8.5 nm unit cell dimension of ASiF cryptocrystals, information storage densities of the order of Tb/cm2 can be possible. Novelties brought by cryptocrystal technology in this field are: i) possibility of writing on microelectronic wafers without photolithography, ii) offer of high density information storage at Tb/cm2 range, iii) high speed erasing and rewriting.

In information security applications, cryptocrystals are used in vertical cavity lasers or LED's [A.C. Tpper, H.D. Foreman, A.Garnache, K.G. Wilcox, S.H. Hoogland, J.Phys. D:Appl. Phys. 37, R75(2004)], right above the active region(32) and top Bragg reflector (35) forming a cryptocrystal window (37). Thus, the laser or LED surface has been transformed into a transparent window. Here the ASiF has to be protected by a cap layer (33). Physical one-way functions can be produced with such a laser/LED chip.The scattering of a He-Ne laser from ASiF(38) shows the feasibility. The scattering indicates the presence of a random structure. This proves that crypto-crystals can be used in generating secure keys in information security. This method is more cost effective and can be better integrated to IC's compared to CMOS applications [A.Fort,F.Cortigiani, S.Rocchi, and V.Vignoli, Analog Integrated Circuits and Signal Processing 34,97(2003)] and other optical applications using passive elements [R.Pappu, B.Recht, J.Taylor and N.Gershenfeld, Science297,2026(2002)].

This invention is used to bond two wafers together. The method includes the formation of cryptocrystal layers on the surfaces of both wafers by CVP and pressing two wafers together under H2O, Nitrogen or Hydrogen_(H2) at high temperature.

## Claims

1. A silicon wafer bonding method, the method including the formation of cryptocrystal layers on the surfaces of two wafers by Chemical Vapor Processing where a vapor mixture of chemicals is reacted on the wafers which involves the following steps:
a) preparing a Teflon reaction chamber (3) comprising an orifice (11) and conduct ultrasound cleaning processes
b) Preparation of chemical mixture of HF and HNO₃ with ratios (4-10):(1-8) and 25-50% hidrofluoric acid (HF) and 55-75% nitric acid (HN03),
c) Flushing the mixure with Nitrogen and priming mixture with a piece of silicon wafer for 10 seconds,
d) Closing entirely the orifice of the reaction chamber (11) with the wafer to be processed,
e) ensuring the evacuation of reaction by products in the reaction chamber through exhaust channels,
f) Adjusting temperature and pH between 10°C- 50°C and 1-6 respectively
g) Having the vapor of HF and HN03, reacted on the silicon wafer surface according to the following Silicon mediated reaction
Si + 6HF + 2HNO₃ → (NH⁴)₂SiF₆ + 3O₂
thereby transforming the wafer surface into a cryptocrystal layer at a rate of 1 µm/h
the method further including pressing the wafer surfaces under H2O, Nitrogen or Hydrogen at high temperature.

2. A method according to claim 1, wherein cryptocrystals' dielectric constant is tunable.

## Patentansprüche

1. Verfahren zum Verbinden von Siliziumwafern, wobei das Verfahren die Bildung von kryptokristallinen Schichten auf den Oberflächen von zwei Wafern durch chemische Gasphasenbehandlung einschließt, bei der eine Dampfmischung von Chemikalien auf den Wafern umgesetzt wird, was die folgenden Schritte umfasst:
a) Vorbereitung einer Teflon-Reaktionskammer (3) mit einer Öffnung (11) und Durchführung von Ultraschallreinigungsprozessen,
b) Herstellung einer chemischen Mischung aus HF und HNO₃ im Verhältnis (4-10):(1-8) und 25-50% Fluorwasserstoffsäure (HF) und 55-75% Salpetersäure (HN03),
c) Spülen des Gemisches mit Stickstoff und Grundierung des Gemisches mit einem Stück Siliziumplättchen für 10 Sekunden,
d) Vollständiges Verschließen der Öffnung der Reaktionskammer (11) mit dem zu bearbeitenden Wafer,
e) Sicherstellung der Evakuierung von Reaktionsnebenprodukten in der Reaktionskammer durch Abluftkanäle,
f) Einstellen der Temperatur und des pH-Werts zwischen 10°C-50°C und beziehungsweise 1-6,
g) Bereitstellung von HF- und HN03-Dampf, der auf der Silizium-WaferOberfläche gemäß der folgenden, durch Silizium vermittelten Reaktion reagiert,
Si + 6HF + 2HNO₃ → (NH⁴)₂SiF₆ + 3O₂
wodurch die Waferoberfläche mit einer Geschwindigkeit von 1 µm/h in eine kryptokristalline Schicht umgewandelt wird,
das Verfahren umfasst ferner das Pressen der Waferoberflächen unter H2O, Stickstoff oder Wasserstoff bei hohen Temperaturen.

2. Verfahren nach Anspruch 1, wobei die Dielektrizitätskonstante der Kryptokristalle abstimmbar ist.

## Revendications

1. Procédé de collage de tranche de silicium, le procédé comprenant la formation de couches cryptocristalline sur les surfaces de deux tranches par Traitement Chimique En Phase Vapeur où un mélange de vapeur de produits chimiques est mis à réagir sur les tranches, ce qui implique les étapes suivantes :
a) Préparation d'une chambre de réaction en Téflon (3) comprenant un orifice (11) et conduire des procédés de nettoyage par ultrasons
b) Préparation d'un mélange chimique de HF et HNO₃ avec des ratios (4-10):(1-8) et 25-50% d'acide fluorhydrique (HF) et 55-75% d'acide nitrique (HNO3),
c) Rinçage du mélange avec de l'Azote et amorçage du mélange avec une pièce de tranche de silicium pendant 10 secondes,
d) Fermeture complète de l'orifice de la chambre de réaction (11) avec la tranche à traiter,
e) Assurer l'évacuation de la réaction par les produits dans la chambre de réaction au travers des canaux d'échappement,
f) Ajustement de la température et du pH entre 10°C- 50°C et 1-6, respectivement,
g) Faire réagir la vapeur de HF et de HN03, sur la surface de la tranche de silicium selon la réaction médiée par le Silicium suivante
Si + 6HF + 2HNO₃ → (NH4)₂SiF₆ + 3O₂
transformant ainsi la surface de la tranche en une couche cryptocristalline à une vitesse de 1 µm/h
le procédé comprenant en outre le pressage des surfaces des tranches sous H2O, azote ou hydrogène à haute température.

2. Procédé selon la revendication 1, dans lequel la constante diélectrique des cryptocristaux est accordable.
